# EUROPÄISCHE PATENTANMELDUNG

(11) **EP 1 107 323 A2**
(43) Veröffentlichungstag der Anmeldung: **13.06.2001**
(21) Anmeldenummer: 00811048.8
(22) Anmeldetag: 08.11.2000
(51) Int. Cl.: H01L 39/16

(54) **Hochtemperatursupraleiteranordnung**

(30) Priorität: 02.12.1999 DE 19957982
(71) Anmelder: ABB RESEARCH LTD., 8050 Zürich (CH)
(72) Erfinder: Chen, Makan, 5405 Baden-Dättwil (CH); Paul, Willi, 5430 Wettingen (CH)
(74) Vertreter: ABB Patent Attorneys

(57) **Zusammenfassung**

Beim Abkühlen von Hochtemperatursupraleiteranordnungen, bei welchen zwischen einem Supraleiter 1 und einem elektrischen Bypass 2 eine elektrisch leitende Übergangsschicht 3 auf Polymerverbundbasis vorgesehen ist, entstehen in Letzterer thermomechanische Spannungen. Um diese zu verringern und die Ausbildung von Rissen zu verhindern wird der Wärmeausdehnungskoeffizient der Übegangsschicht 3 reduziert. Dies geschieht durch Zugabe eines geeigneten Füllmaterials 32, beispielsweise von Partikeln aus SiO₂, AL₂O₃ oder AlN, in den Polymerverbundstoff.

## Beschreibung

### TECHNISCHES GEBIET

Die vorliegende Erfindung bezieht sich auf das Gebiet der Hochtemperatursupraleiter. Sie betrifft eine Hochtemperatursupraleiteranordnung gemäss dem Oberbegriff des Patentanspruchs 1.

### STAND DER TECHNIK

In der Europäischen Patentanmeldung EP-A 0 911 889 ist eine Hochtemperatursupraleiteranordnung zur Verwendung in einem Strombegrenzer dargestellt. Die Anordnung umfasst eine supraleitende Schicht und eine als elektrischer Bypass ausgebildete, gelochte Stahlplatte, welche mit der supraleitenden Schicht einen Leiterverbund bildet. Der Bypass ist mittels eines leitfähigen Epoxidharzes auf den Supraleiter aufgeklebt. Diese zur Verbesserung des Kontaktwiderstandes zwischen Supraleiter und Bypass vorgesehene leitende Übergangs-oder Zwischenschicht ermöglicht es dem Strom, von der einen in die andere Schicht zu wechseln.

Die genannte Übergangsschicht besteht beispielsweise aus einem leitenden Polymerverbundstoff, welcher eine elektrisch isolierende polymere Harzgrundmasse und einen elektrisch leitenden Füllstoff umfasst. Als Füllstoff in Frage kommen Metallpulver, -fasern oder -flocken sowie metallisierte Teilchen oder Partikel. Der Füllstoff muss in einem ausreichenden Volumenanteil eingesetzt werden, damit die einzelnen Teilchen oder Fasern elektrischen Kontakt miteinander haben und der entstehende Verbundstoff leitend ist.

Zur Kühlung auf Betriebstemperatur werden Hochtemperatursupraleiter mit einem Kühlmedium, vorzugsweise mit flüssigem Stickstoff LN2, in thermischen Kontakt gebracht. Infolge der unterschiedlichen thermischen Ausdehnungskoeffizienten von Supraleiter und Bypass auf der einen Seite und Polymerverbundstoff auf der anderen Seite kommt es bei dieser Abkühlung zu Spannungen. Insbesondere die Polymerverbundstoffschicht, welche einen grossen thermischen Ausdehnungskoeffizienten aufweist, wird durch die sich weniger stark kontrahierenden benachbarten Schichten unter Zugspannung gesetzt und bildet Risse aus.

In der Patentschrift EP-B 0 257 466 ist ein Laminat aus einer Metallschicht und einer Schicht aus einem ausgehärteten Polymermatrix-Verbundmaterial offenbart, welches beispielsweise zur Kühlung von auf einer Leiterplatte angebrachten elektronischen Bauteilen dient. In die Verbundmaterialschicht ist ein verstärkendes, wärmeleitendes Material geringer thermischer Ausdehnung in Form von Teilchen, Fasern oder Geweben eingebracht. Diese Schicht dient der Wärmeleitung zwischen der Wärmequelle (den elektronischen Bauteilen) und der Wärmesenke (Metallschicht) sowie zum Angleich der thermischen Ausdehnungskoeffizienten von Leiterplatte und Metallschicht. Die Verbundschicht ist elektrisch nichtleitend und so konzipiert, dass die im Betrieb sich erwärmenden Bauteile gut gekühlt werden können.

### DARSTELLUNG DER ERFINDUNG

Aufgabe der vorliegenden Erfindung ist es, bei einer Hochtemperatursupraleiteranordnung der eingangs genannten Art die beim Abkühlen auf Betriebstemperatur entstehenden thermomechanischen Spannungen in einer zwischen einem Supraleiter und einem elektrischen Bypass vorgesehenen elektrisch leitenden Übergangsschicht auf Polymerverbundbasis zu verringern und die Ausbildung von Rissen in der Übergangsschicht zu verhindern. Diese Aufgabe wird durch eine Hochtemperatursupraleiteranordnung mit den Merkmalen des Patentanspruchs 1 gelöst.

Kern der Erfindung ist es, durch den Einsatz von geeigneten Mitteln den thermischen Ausdehnungskoeffizienten der Übergangsschicht zu reduzieren. Letzterer nähert sich dadurch den unveränderten thermischen Ausdehnungskoeffizienten von Supraleiter und elektrischem Bypass an und die beim Abkühlen der Anordnung auftretenden Zugspannungen in der Übergangsschicht werden vermindert.

In einer ersten bevorzugten Ausführungsform ist dem leitenden Polymerverbundstoff ein zweiter, elektrisch nichtleitender Füllstoff beigemischt. Dieser weist vorzugsweise einen thermischen Expansionskoeffizienten auf, welcher kleiner ist als derjenige der Polymermatrix.

In einer weiteren Ausführungsform sind dem Polymerverbundstoff zusätzlich Fasern zur Verbesserung der mechanischen Stabilität zugegeben.

Weitere vorteilhafte Ausführungsformen gehen aus den abhängigen Patentansprüchen hervor.

### KÜRZE BESCHREIBUNG DER FIGUREN

Nachfolgend wird die Erfindung anhand eines Ausführungsbeispiels im Zusammenhang mit der Zeichnung näher erläutert. Es zeigt

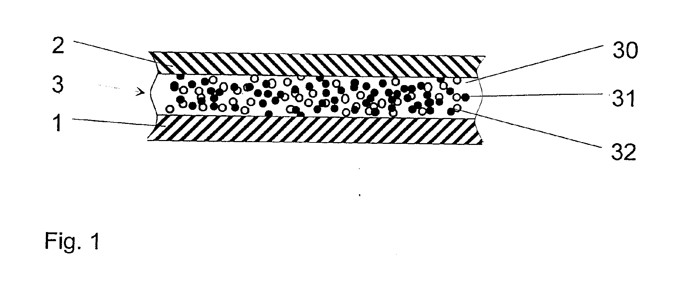

Fig.1, eine Hochtemperatursupraleiteranordnung mit einer erfindungsgemäss modifizierten Polymerverbund-Übergangsschicht.

Die in der Zeichnung verwendeten Bezugszeichen sind in der Bezugszeichenliste zusammengefasst.

### WEGE ZUR AUSFÜHRUNG DER ERFINDUNG

In Fig.1 ist ein Ausschnitt aus einem Querschnitt durch eine Hochtemperatursupraleiteranordnung, wie sie beispielsweise in Strombegrenzern Verwendung findet, dargestellt. Ein Hochtemperatursupraleiter 1 ist über eine Hauptfläche mit einer elektrischen Bypassschicht 2 flächenhaft verbunden und bildet mit dieser einen Leiterverbund. Zwischen diesen beiden Schichten 1,2 befindet sich eine Übergangsschicht 3 auf der Basis eines Polymerverbundes. Dieser umfasst eine Polymermatrix 30, ein leitendes erstes Füllmaterial 31 und ein nichtleitendes zweites Füllmaterial 32.

Für die in der Zeichnung dargestellte Hochtemperatursupraleiteranordnung und die folgende, sich darauf beziehende Beschreibung wurde eine planare Geometrie gewählt. Diese kann symmetrisch ergänzt werden, indem beispielsweise eine zweite Bypassschicht auf einer der ersten Bypassschicht 2 gegenüberliegenden Seite des Supraleiters 1 angebracht wird. Die Erfindung kann genausogut bei Kabeln oder Drähten mit einem supraleitenden Kern, welcher von einem elektrischen Bypass umgeben ist, Verwendung finden. Bei der letztgenannten, axialsymmetrischen Anordnung wie auch bei den vorgängig genannten planaren Ausführungen mit einer Symmetrieebene ist sichergestellt, dass die thermisch induzierte Längenänderung in einer Richtung parallel zur Symmetrieachse oder -ebene verläuft und zu keiner bimetallartigen Distorsion der Anordnung führt.

Die Übergangsschicht 3 umfasst einen Polymerverbundstoff mit einer Matrix 30 und mindestens einem leitenden Füllmaterial 31. Die Matrixsysteme sind vorzugsweise dreidimensional vernetzende Duroplaste und basieren beispielsweise auf Epoxid-, Silizium- oder Polyesterharzen. Der thermische Ausdehnungskoeffizient einer solchen Polymermatrix 30 liegt im Bereich von 60-100·10⁻⁶/K, demgegenüber beträgt der thermische Ausdehnungskoeffizient des keramischen Supraleiters 1 typischerweise etwa 10·10⁻⁶/K, und derjenige eines Bypass 2 aus Stahl rund 15·10⁻⁶/K. Beim Abkühlen der Anordnung von Raumtemperatur beziehungsweise der Aushärtetemperatur der Polymermatrix 30 auf Betriebstemperatur (77K) würde sich der Polymerverbund also viel stärker zusammenziehen als die benachbarten Schichten. Da die tatsächlich resultierende Längenänderung für alle Schichten der Anordnung gleich ist, bauen sich entsprechend Spannungen auf, welche insbesondere bei mehreren thermischen Zyklen, d.h. wiederholtem Erwärmen und Abkühlen, zu Rissen in der Übergangsschicht 3 führen können.

Zur Verringerung der genannten Spannungen wird erfindungsgemäss vorgeschlagen, den thermischen Ausdehnungskoeffizienten der Übergangsschicht 3 zu reduzieren, vorzugsweise auf einen Wert, welcher gegebenenfalls nur noch 2-3 mal grösser ist als derjenige des Stahl-Bypass 2.

Der leitende Füllstoff 31 besteht beispielsweise aus Silberpartikeln und weist häufig selbst einen geringen thermischen Ausdehnungskoeffizienten auf. Eine Erhöhung der Teilchendichte des leitenden Füllstoffs, d.h. der Anzahl Silberpartikel pro Volumen, bewirkt somit bereits eine Reduktion des Wärmeausdehnungskoeffizienten des Polymerverbundes. Aus Kostengründen und um die elektrischen Eigenschaften der Übergangsschicht 3 nicht unkontrolliert zu beeinflussen, kann statt dessen ein zweiter, nichtleitender Füllstoff 32 zugegeben werden. Dieser besteht aus kleinen Teilchen oder Fasern mit einem Durchmesser von 1-100 µm, aus einem Material mit einem kleinen Wärmeausdehnungskoeffizienten von vorzugsweise weniger als 10·10⁻⁶/K. In Frage kommen Quarz (SiO₂), Aluminiumoxid (Al₂O₃) oder Aluminiumnitrid (AlN), wobei sich die zwei Letztgenannten zusätzlich durch ihre wärmeleitenden und wärmespeichernden Eigenschaften auszeichnen.

Die mechanischen Eigenschaften einer derartigen Übergangsschicht auf Polymerverbundbasis können verbessert werden, indem ihr ähnlich einer Faserverbundschicht Glas-, Kohlenstoff-oder Aramidfasern als verstärkendes Trägermaterial beigegeben werden. Eine derartig modifizierte Schicht weist beispielsweise eine höhere Biegefestigkeit auf und dient somit gleichzeitig zur mechanischen Stabilisierung des Leiterverbundes.

Ein Polymerverbund nach der Erfindung wird präpariert, indem einem Epoxyharz zwischen 10 und 40 Volumen% Silberpulver und annähernd gleichviel eines zweiten, nichtleitenden Füllmaterials beigemischt wird. Der Polymerverbund wird daraufhin grossflächig und gleichmässig auf eine erste Schicht des Leiterverbundes aufgetragen. Anschliessend wird die angehende Übergangsschicht mit der zweiten Schicht des Leiterverbundes zur Deckung gebracht und unter Vakuum ausgehärtet. Zur Auftragung einer viskosen Schicht mit kontrollierter Dicke eignen sich Siebdruck- oder, unter Zuhilfenahme eines Lösungsmittels, auch Farbspritzverfahren.

### BEZUGSZEICHENLISTE

- 1: Supraleiter
- 2: elektrischer Bypass
- 3: Übergangsschicht, Polymerverbundstoff
- 30: Polymermatrix
- 31: Erstes Füllmaterial, z.B. Silberpartikel
- 32: Zweites Füllmaterial

## Patentansprüche

1. Hochtemperatursupraleiteranordnung mit einem Supraleiter (1) und einem elektrischen Bypass (2), welcher über eine elektrisch leitende Übergangsschicht (3) mit dem Hochtemperatursupraleiter (1) in elektrischem Kontakt steht, wobei die Übergangsschicht (3) einen Polymerverbundstoff mit einer Polymermatrix (30) und einem elektrisch leitenden ersten Füllmaterial (31) umfasst, dadurch gekennzeichnet, dass Mittel (32), welche vom ersten Füllmaterial (31) verschieden sind, zur Reduzierung des thermischen Ausdehnungskoeffizienten der Übergangsschicht (3) vorhanden sind.

2. Anordnung nach Anspruch 1, dadurch gekennzeichnet, dass die Mittel ein zweites, elektrisch nichtleitendes Füllmaterial (32) sind, welches dem Polymerverbundstoff beigemischt ist.

3. Anordnung nach Anspruch 2, dadurch gekennzeichnet, dass der thermische Ausdehnungskoeffizient des zweiten Füllmaterials (32) kleiner ist als der thermische Ausdehnungskoeffizient der Polymermatrix (30).

4. Anordnung nach Anspruch 3, dadurch gekennzeichnet, dass die Polymermatrix (30) ein Epoxyharz ist, und der zweite Füllstoff (32) Quarz (SiO₂), Aluminiumoxid (Al₂O₃) oder Aluminiumnitrid (AlN) umfasst.

5. Anordnung nach Anspruch 2, dadurch gekennzeichnet, dass der thermische Ausdehnungskoeffizient des Polymerverbundstoffes kleiner als der dreifache thermische Ausdehnungskoeffizient des elektrischen Bypass (2) ist.

6. Anordnung nach einem der vorhergehenden Ansprüche, dadurch gekennzeichnet, dass der Polymerverbundstoff zusätzlich Fasern zur mechanischen Verstärkung aufweist.
